(19) Europäisches Patentamt
European Patent Office
Office européen des brevets

(11) **EP 4 225 969 B1**

(12) **EUROPÄISCHE PATENTSCHRIFT**

(45) Veröffentlichungstag und Bekanntmachung des Hinweises auf die Patenterteilung:
**26.11.2025 Patentblatt 2025/48**

(21) Anmeldenummer: **21787373.6**

(22) Anmeldetag: **05.10.2021**

(51) Internationale Patentklassifikation (IPC):
*G01J 5/00* (2022.01)    *C23C 16/52* (2006.01)
*H01L 21/67* (2006.01)    *C23C 16/458* (2006.01)
*H01L 21/687* (2006.01)

(52) Gemeinsame Patentklassifikation (CPC):
**G01J 5/0003; C23C 16/4584; C23C 16/52;
G01J 5/0007; H01L 21/67103; H01L 21/67248;
H01L 21/68764; H01L 21/68771; G01J 2005/0074**

(86) Internationale Anmeldenummer:
**PCT/EP2021/077333**

(87) Internationale Veröffentlichungsnummer:
**WO 2022/073951 (14.04.2022 Gazette 2022/15)**

(54) **VERFAHREN ZUR EMISSIVITÄTSKORRIGIERTEN PYROMETRIE**

METHOD FOR EMISSIVITY-CORRECTED PYROMETRY

PROCÉDÉ DE PYROMÉTRIE À ÉMISSIVITÉ CORRIGÉE

(84) Benannte Vertragsstaaten:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorität: **09.10.2020 DE 102020126597**

(43) Veröffentlichungstag der Anmeldung:
**16.08.2023 Patentblatt 2023/33**

(73) Patentinhaber: **Aixtron SE
52134 Herzogenrath (DE)**

(72) Erfinder:
• **ROJEK, Karsten
41061 Mönchengladbach (DE)**
• **HEYDHAUSEN, Dirk
52080 Aachen (DE)**

(74) Vertreter: **Grundmann, Dirk et al
Rieder & Partner mbB
Patentanwälte - Rechtsanwalt
Yale-Allee 26
42329 Wuppertal (DE)**

(56) Entgegenhaltungen:
JP-A- 2018 166 204    US-B1- 6 349 270
US-B1- 6 398 406

• **YAN DONG ET AL: "In-Situ Temperature Monitoring and Deposition Induced Errors Calibration in Metal-Organic Chemical Vapor Deposition", 2013 THIRD INTERNATIONAL CONFERENCE ON INSTRUMENTATION, MEASUREMENT, COMPUTER, COMMUNICATION AND CONTROL, IEEE, 21 September 2013 (2013-09-21), pages 897 - 900, XP032609647, DOI: 10.1109/IMCCC.2013.199**
• **GURARY ALEX ET AL: "Application of Emissivity Compensated Pyrometry for Temperature Measurement and Control During Compound Semiconductors Manufacturing", AIP CONFERENCE PROCEEDINGS, 23 October 2003 (2003-10-23), XP055876770, Retrieved from the Internet <URL:https://aip.scitation.org/doi/pdf/ 10.1063/1.1627233> [retrieved on 20220107], DOI: 10.1063/1.1627233**
• **BREILAND W G: "Reflectance-Correcting Pyrometry in Thin Film Deposition Applications", vol. 2003-1868, 1 June 2003 (2003-06-01), pages 1 - 85, XP007923097, Retrieved from the Internet <URL:http://prod.sandia.gov/techlib/ access-control.cgi/2003/031868.pdf>**

- **BRUNNER F ET AL: "Advancedcontrol for III-nitride RF power device epitaxy", SEMICONDUCTOR SCIENCE TECHNOLOGY, IOP PUBLISHING LTD, GB, vol. 33, no. 4, 26 March 2018 (2018-03-26), pages 45014, XP020325440, ISSN: 0268-1242, [retrieved on 20180326], DOI: 10.1088/1361-6641/AAB410**

**Beschreibung**

<u>Gebiet der Technik</u>

Die Erfindung betrifft ein Verfahren zum Beschichten von Substraten mit einer Mehrschichtstruktur, die einen ersten Abschnitt und einen auf den ersten Abschnitt abgeschiedenen zweiten Abschnitt aufweist, wobei während des Abscheidens zumindest des zweiten Abschnitts mit mindestens einer optischen Messeinrichtung an der die Schicht aufweisenden Breitseite des Substrates ein Emissivitätswert und ein Reflektanzwert gemessen wird, wobei unter Verwendung eines zuvor bestimmten Korrekturwertes ein Istwert einer Temperatur der Breitseite des Substrates berechnet wird und unter Verwendung des Istwertes eine Heizeinrichtung zum Temperieren des Substrates gegen einen Sollwert der Temperatur der Breitseite des Substrates geregelt wird.

Die Erfindung betrifft darüber hinaus eine Vorrichtung zur Durchführung des Verfahrens die Recheneinrichtung derart programmiert ist, dass der Korrekturwert während des Abscheidens eines ersten Abschnitts der Mehrschichtstruktur auf dem Substrat unmittelbar vor dem Abscheiden des zweiten Abschnitts der Mehrschichtstruktur auf der ersten Schichtanordnung bestimmt wird.

<u>Stand der Technik</u>

Die US 6,398,406 B1 bildet den technischen Hintergrund der Erfindung. Das dort beschriebene Verfahren der emissivitätskorrigierten Pyrometrie, auch als reflektivitäts- oder reflektanzkorrigiert oder emissivitätskompensiert bezeichnet, und dessen Einsatz zur berührungsfreien optischen Temperaturmessung während der Dünnschichtabscheidung bei unbekannten und sich fortlaufend ändernden optischen Eigenschaften des Messobjekts. Bei dem Verfahren der Pyrometrie zur berührungsfreien Temperaturmessung macht man sich den Zusammenhang zwischen der von dem heißen Messobjekt emittierten thermischen Strahlung und der Temperatur des Objekts zu Nutze, der durch die bekannte Planck'sche Strahlungsgleichung beschrieben wird und in der Praxis durch eine entsprechende vorhergehende Kalibration bis auf den Emissionsgrad des Objekts eindeutig erfasst wird. Das Messobjekt kann jede für die Überwachung oder Regelung der Temperatur relevante und optisch zugängliche Oberfläche in der Prozesskammer sein. Für diese Erfindung ist das Messobjekt insbesondere die Oberfläche des Substrats bzw. der Substrate in der Prozesskammer während des Abscheidungsprozesses, bei dem eine Halbleiterschichtstruktur mit unterschiedlichen nahezu stöchiometrischen Verbindungen aus der Gruppe III (Al, Ga, In) und aus Stickstoff erzeugt wird.

Stand der Technik ist auch folgende Veröffentlichung:

W. G. Breiland, Technical Report SAND2003-1868, June 2003, öffentlich zugänglich z.B.:

https://www.osti.gov/biblio/820889 oder
https://prod-ng.sandia.gov/techlib-noauth/access-control.cgi/2003/031868.pdf
nachfolgend mit Breiland 2003 bezeichnet.

Zum Stand der Technik gehört auch die DE 102018106481 A1, die eine gattungsgemäße Vorrichtung beschreibt.

Das bekannte Verfahren der Emissivitätskorrektur beruht darauf den fehlenden unbekannten Emissionsgrad durch Messung der Reflektanz der Oberfläche des Messobjekts zu bestimmen. Die Emissivität wird mit Hilfe des Kirchhoff'schen Gesetzes für den Fall lichtundurchlässiger Substrate zu $\varepsilon = 1 - \rho$ ermittelt. Die Detektionswellenlänge des Pyrometers wird so gewählt, dass das gewählte Substrat (hier Silizium) für die Wellenlänge bei den typischen Betriebstemperaturen (T = 600 - 1200°C) lichtundurchlässig ist, also bei einem Wert in der Spanne 800 nm bis 1000 nm. Die Reflektanz wird bei exakt derselben Wellenlänge wie die thermische Emission gemessen, damit das Verfahren ausreichend genau funktioniert. Das hierzu erforderliche Licht kann von einem Laser bereitgestellt werden. In der Praxis haben die Pyrometer keine scharfe Messwellenlänge sondern weisen ein Wellenlängenintervall auf (etwa $\pm$ 10 nm, aber auch enger oder weiter). Diese Intervallbreite und die Schwerpunktwellenlänge von Emissions- und Reflektanzmessung müssen möglichst gut übereinstimmen. Die Reflektanz wird gemessen, indem Licht der definierten Wellenlänge am Ort des Sensors ausgesandt wird, bei vertikalem Einfall an der Waferoberfläche reflektiert wird und möglichst am selben Ort wie die Pyrometermessen reflektiert wird. Aus der gemessenen Signalintensität des reflektierten Lichts wird mit Hilfe einer vorhergehenden Kalibration die Reflektanz bestimmt. In der Praxis kann die thermische Emission des Objekts und die Reflektanz oftmals nicht gleichzeitig sondern alternierend zeitlich getrennt gemessen werden, damit die Reflektanzmessung nicht die Messung der thermischen Emission stört.

Für die genaue Messung der Temperatur sind zwei unterschiedliche Kalibrierschritte erforderlich; die Durchführung der Kalibrierungen erlaubt die Bestimmung von Kalibrierparametern, welche in die Berechnung der Temperatur aus den Messsignalen einfließen. Es handelt sich dabei um die Kalibrierung der Emissionsmessung unter Verwendung einer Schwarzkörperstrahlungsquelle (Schwarzkörperofen, spezielle Referenzquellen), welche die Verknüpfung von Intensitätssignal und Messtemperatur herstellt. Bei der Messung erlaubt die Verwendung der so ermittelten Kalibrierparameter die Ermittlung der noch nicht um den Effekt der unbekannten Emissivität korrigierten sogenannten Rohtemperatur. Ein davon unabhängiger Kalibrierschritt dient der Ermittlung eines Kalibrierparameters, so dass jedem gemessenen Reflektanzsignal ein Reflektanzwert aus dem Intervall 0...1 zuordnet wird. Dieser Kalibrierschritt wird auf Substraten gut bekannter Reflektanz (beziehungsweise Emissionsgrad bei opaken Substraten) durchgeführt, etwa Silizium unmittelbar nach dem Prozessschritt der Desorption *(native oxide removal)* bei bekannter Temperatur und nicht verunreinigter Oberfläche und noch vor dem Beginn der Schichtabscheidung.

Die Berechnung der Temperatur beim Messvorgang erfolgt zunächst, wie bei Breiland 2003 beschrieben, durch:

$$\frac{1}{T_C} = \tau - \frac{\lambda}{c_2} ln\left(\frac{E}{1-R}\right) \qquad (1)$$

mit

$$\tau = \frac{1}{T_{cal}} - \frac{\lambda}{c_2} ln\left(\frac{1-R_{cal}}{S_{cal}}\right) \quad (2)$$

Dabei handelt es sich bei den Bezeichnungen im obigen Ausdruck um folgende Größen:

$T_C$ : Emissivitätskorrigierte Temperatur
$E$ : Kalibriertes Signal der Messung der thermischen Emission (Linearer Zusammenhang zwischen Messsignal und einfallender Strahlung)
$R$ : kalibriertes Signal der Reflektanzmessung (Linearer Zusammenhang zwischen Messsignal und einfallender Strahlung)
$T_{cal}, S_{cal}$: Kalibrierparameter zur Ermittlung der Rohtemperatur
$R_{cal}$: Kalibrierparameter der Reflektanzmessung
$\lambda$: Wellenlänge von Pyrometer und Reflektanzmessung
$c_2$: zweite Strahlungskonstante

Die Ausdrücke lassen sich wie folgt vereinfachend umformen:

$$T_C = \frac{B}{\log E - A + \log(1-R)} \qquad (3)$$

$A, B$ : Kalibrierparameter zur Ermittlung der Rohtemperatur

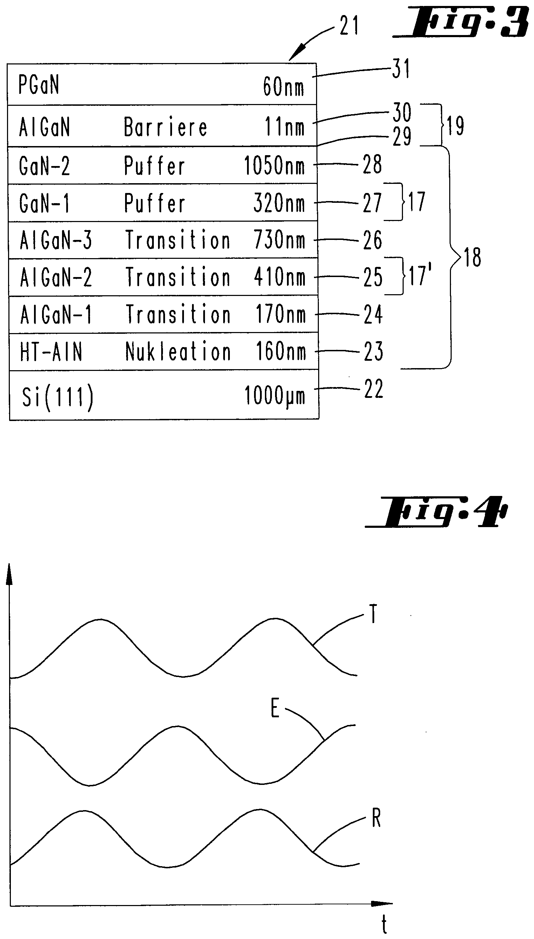

Beim Abscheiden einer dünnen Schicht mit konstanter Wachstumsgeschwindigkeit wird ohne den Einsatz des beschriebenen bekannten Verfahrens der Emissivitätskorrektur eine sinusförmig oszillierende Temperaturmessung beobachtet, die mit den Interferenzeffekten in der durchsichtigen dünnen Schicht zusammenhängen (Fabry-Perot-Oszillationen). Im konkreten Fall der MOCVD Abscheidung von GaN oder AlGaN auf Silizium bei Temperaturen im Bereich von 950 bis 1100°C betragen die Oszillationen bis zu ±30°C (siehe auch Figur 4). Ziel des Verfahrens ist es, die Temperaturoszillationen auf unter ±2°C, besser noch ±1°C zu reduzieren.

Führt man das im Stand der Technik in Breiland 2003 beschriebene Temperaturmessverfahren wie beschrieben aus, tritt eine Reihe von Fehlern auf, die im Folgenden beschrieben werden. Diese Fehlerquellen führen allesamt dazu, dass die Emissivitätskorrektur unvollständig oder artifiziell überhöht durchgeführt wird. Die fehlerhafte Emissivitätskorrektur äußert sich in verbleibenden Temperaturoszillationen, deren Amplitude größer als das gewünschte Fehlermaß ist.

Es hat sich gezeigt, dass insbesondere das Materialsystem GaN (AlGaN) auf Silizium für die beschriebenen Fehlerquellen besonders anfällig ist, weil aufgrund der Werte der Brechungsindizes für das Schicht- und des Wafermaterial sowie aufgrund des Aufeinandertreffens von lichtdurchlässiger Schicht und opakem Substrat die gemessenen Reflektanzwerte R zwischen Werten von nahe Null und 0.5 oszillieren.

Bei den beobachteten Fehlerquellen kann es sich um folgende Fehler handeln, die auch in der Praxis auftreten

- Unbekannter exakter Wert der Reflektanz des Kalibrierobjekts bei der Reflektanzkalibrierung, so dass der Wert der bei der Kalibrierung verwendeten Reflektanz nicht mit der physikalischen Reflektanz übereinstimmt, und die für die Emissivitätskorrektur verwendeten Reflektanzwerte fehlerhaft sind.

- Fehler bei der Justage und Einrichtung der Messoptik.
- Streuung an Schichtgrenzen in der Halbleiterschichtstruktur bei der Messung der Reflektanz, so dass ein Teil des tatsächlich reflektierten Lichts nicht erfasst wird.
- Streustrahlung von heißen Oberflächen der Prozesskammer, die durch Mehrfachreflexion an Prozesskammerwänden und an der Waferoberfläche in den Messkopf gelangt.

Bei der Produktion von elektronischen Bauelementen, etwa Transistoren für Schaltungen zur Leistungswandlung oder Hochfrequenzverstärkung ist die Kontrolle und Wiederholgenauigkeit des Abscheidungsprozesses und die Ausbeute der verwendbaren Bauelemente pro Wafer bei der der Erfindung zugrundeliegenden Ausführungsform des bekannten Verfahren stark beeinträchtigt, weil die gemessene Wafertemperatur für die Temperaturregelung in einem geschlossenen Regelkreis verwendet wird. Die Temperaturregelung regelt eine Heizeinrichtung so, dass die gemessene Temperatur konstant einem bestimmten Sollwert entspricht; die physikalische Temperatur oszilliert dann entsprechend um die verbleibende Amplitude der nicht vollständig korrigierten Temperaturoszillationen, die ein Messartefakt darstellen. Das Bauelement besitzt eine auf ein Substrat abgeschiedene Mehrschichtstruktur, die einen ersten Abschnitt und einen zweiten Abschnitt aufweist. Im ersten Abschnitt werden Übergangsschichten, insbesondere AlGaN und Bufferschichten, insbesondere aus GaN abgeschieden. Auf die Bufferschicht aus GaN wird eine AlGaN-Barriereschicht abgeschieden derart, dass sich im Bereich der Schichtgrenze zwischen der GaN-Schicht und der AlGaN-Barriereschicht ein zweidimensionales Elektronengas ausbildet. Die Beeinträchtigung in der Reproduzierbarkeit hängt insbesondere damit zusammen, dass die Bauelementstruktur typischerweise aus einer Abfolge von Funktionsblöcken zusammengesetzt ist, die aus einer dünnen AlN Keimschicht auf dem Si-Substrat, einer Übergangsschichtfolge, einer dicken GaN-Pufferschichtfolge und einer relativ dünnen aber temperaturempfindlichen Barriereschicht aus AlGaN oder AlInN besteht. Am Ende der Pufferschicht wird je nach zufälliger Phasenlage der verbleibenden Messtemperaturoszillation die Abweichung der physikalischen Temperatur vom Sollwert von Run zu Run oder von Wafer zu Wafer unterschiedliche Werte aufweisen, die sich etwa in unterschiedliche Werte der für die Bauelementfunktion kritischen Zusammensetzung der Barriereschicht übertragen.

Für die Kompensation der oben dargestellten Fehlerquellen wird im Stand der Technik (Breiland 2003) folgende theoretische Korrektur dieses Messverfahrens angeführt:

Ausgangspunkt für die Betrachtung ist die mathematisch herleitbare Tatsache, dass die Auswirkung einer Reihe von Fehlerquellen durch einen zusätzlichen Korrekturwert $\gamma$ effektiv kompensiert werden kann, so dass die verbleibenden Oszillationen theoretisch gegen Null reduziert werden.

Die Korrektur erfolgt dabei wie folgt:

$$\frac{1}{T_C} = \tau - \frac{\lambda}{c_2} ln\left(\frac{E}{1 - R + \gamma}\right) \qquad (4)$$

mit

$$\tau = \frac{1}{T_{cal}} - \frac{\lambda}{c_2} ln\left(\frac{1 - R_{cal} + \gamma}{S_{cal}}\right)$$

Die mathematische Äquivalenz der eingeführten Korrektur um den Parameter $\gamma$ zur Korrektur der oben angeführten, auftretenden Fehlerquellen kann in allgemeiner Form gezeigt werden. Hierbei kann $\gamma$ linear von R abhängig sein. Der off-set von $\gamma$ ist ausschließlich von Reflektionen der Lichtquelle innerhalb der Messoptik abhängig. Der off-set kann mit einem zusätzlichen Kalibrierschritt ausgeglichen werden. Alle weiteren Anteile sind linear abhängig von R. In einer vereinfachten Darstellung mit $\gamma = \gamma$ (R) können die obigen Ausdrücke wie folgt umgeformt werden:

$$T_C = \frac{B}{\log E - A + \log(1 - \gamma \cdot R)} \qquad (5)$$

Zur Ermittlung des zusätzlichen Kalibrierparameters $\gamma$ wird in der US 6,398,406 B1 beziehungsweise Breiland 2003 vorgeschlagen, einen vollständigen Beschichtungsrun für eine spezifische Halbleiterstruktur, bei der eine möglichst große Oszillation auftritt, nämlich eine DBR Struktur (DBR = Distributed Bragg Reflector), durchzuführen und nach dem Ende des Runs den Parameter $\gamma$ so einzustellen, dass die Oszillationen so weit wie möglich reduziert werden. Der Wert des Parameters $\gamma$ kann entweder manuell oder durch eine Optimierungsaufgabe (die minimum variance Methode) oder durch lineare Regression ermittelt werden.

Das bekannte Vorgehen hat im praktischen Produktionseinsatz zahlreiche Nachteile, wie etwa:

- die Durchführung eines gesonderten Kalibrierruns mit entsprechendem Produktionsausfall.

- Bei der Ermittlung des $\gamma$- Parameters ist das Ausschalten der automatischen Temperaturregelung erforderlich.

- Bei der Durchführung eines Kalibrierruns mit einer speziellen Struktur wird nur ein reaktorspezifischer Parameter $\gamma$ ermittelt aber nicht ein für einzelne Schichten oder andersartige Bauelementstrukturen spezifischer Korrekturparameter $\gamma$. Es wird beobachtet, dass der die Oszillationen minimierende Parameter $\gamma$ für unterschiedliche Einzelschichten in der Bauelementstruktur unterschiedlich sein kann.

- Hoher Personaleinsatz bei erforderlicher häufiger Nachbestimmung der Parameter.

- Subjektive Einschätzung der ausreichenden Abstimmung der Parameter bei manueller Bestimmung.

**Zusammenfassung der Erfindung**

Der Erfindung liegt die Aufgabe zugrunde, bei der Berechnung des Istwertes der Substrattemperatur die tatsächlich auftretenden Fehler und Messartefakte, die zu einem oszillierenden Temperaturwert führen, so zu kompensieren, dass für die Regelung zumindest während des Abscheidens des zweiten Abschnittes der Mehrschichtstruktur, die ein oder mehrere aktive Bereiche aufweist, eine minimal oszillierende berechnete Größe zur Verfügung steht, wobei insbesondere auf einen gesonderten Abscheideprozess zur Ermittlung des Korrekturwertes verzichtet werden kann.

Gelöst wird die Aufgabe durch die in den Ansprüchen angegebene Erfindung, wobei die Unteransprüche nicht nur vorteilhafte Weiterbildungen der nebengeordneten Ansprüche darstellen, sondern auch eigenständige Lösungen der Aufgabe sind.

Zunächst und im Wesentlichen wird an der Oberfläche des Substrates in bekannter Weise ein Emissivitätswert und ein Reflektanzwert gemessen. Es kann gleichzeitig ein Emissivitätswert und ein Reflektanzwert gemessen werden. Es ist aber auch möglich, den Emissivitätswert und den Reflektanzwert in zwei unmittelbar aufeinanderfolgenden Messungen zu bestimmen. Mit den oben beschriebenen Formeln und insbesondere der Formel (5) sowie der ausführlichen Beschreibung in Breiland 2003 kann ein emissivitätskorrigierter Temperatur-Istwert bestimmt werden. Hierzu wird beim Beschichten des Substrates mit einer Mehrschichtstruktur, die einen ersten Abschnitt und einen auf den ersten Abschnitt abgeschiedenen zweiten Abschnitt aufweist, während des Abscheidens des ersten Abschnitts ein Korrekturwert bestimmt. Dieser Korrekturwert wird beim Abscheiden des zweiten Abschnittes zur Berechnung des Istwertes der Substrattemperatur verwendet. Das Verfahren wird in einer Vorrichtung durchgeführt, die eine Recheneinrichtung aufweist, mit der zunächst der Korrekturwert nach dem eingangs beschriebenen Verfahren berechnet wird. Dies erfolgt erfindungsgemäß beim Abscheiden des ersten Abschnittes der Mehrschichtstruktur, der Übergangsschichten aus AlGaN und/oder Bufferschichten aus GaN aufweisen kann. Der unmittelbar vor dem Abscheiden des zweiten Abschnitts der Mehrschichtstruktur ermittelte Korrekturwert wird zur Bestimmung des Istwertes der Substrattemperatur während des Abscheidens des zweiten Abschnitts zur Regelung der Substrattemperatur verwendet. Der zweite Abschnitt der Mehrschichtstruktur enthält bevorzugt die aktiven Schichten beziehungsweise Schichtbereiche der Mehrschichtstruktur. Der zweite Abschnitt kann beispielsweise einen oberen Bereich einer Bufferschicht, aus GaN aufweisen, und zumindest den unteren Bereich einer AlGaN-Barriere oder AlInN-Barriere umfassen, die auf die Bufferschicht abgeschieden wird. Der zweite Abschnitt der Mehrschichtstruktur enthält insbesondere die Bereiche unmittelbar aneinander angrenzender Schichten, die im Bereich ihrer Grenze ein zweidimensionales Elektronengas ausbilden können, sodass die Mehrschichtstruktur zur Fertigung von Feldeffekttransistoren verwendet werden kann.

Aufgrund der erfindungsgemäßen Weiterbildung des bekannten Verfahrens ist die Durchführung eines dem eigentlichen Abscheideprozess der Mehrschichtstruktur vorausgehenden gesonderten Abscheideprozesses zur Ermittlung des Korrekturwertes nicht mehr erforderlich. Der Korrekturwert wird gewissermaßen in situ beim Abscheiden der Mehrschichtstruktur ermittelt, und zwar zeitlich vor dem Abscheiden des aktiven Bereiches der Mehrschichtstruktur. Es ist ferner möglich, beim Abscheiden mehrerer Substrate für jedes Substrat einen individuellen Korrekturwert zu bestimmen.

Eine bevorzugte Ausgestaltung des Verfahrens besteht insbesondere darin, dass der erste Abschnitt der Mehrschichtstruktur eine Vielzahl von Buffer- oder Übergangs-Schichten aufweist. Bevorzugt weist der zweite Abschnitt der Mehrschichtstruktur zumindest eine Barriereschicht auf. Bevorzugt erfolgt die Messung des Emissivitätswertes und/oder des Reflektanzwertes bei einer Wellenlänge, die in einem Bereich zwischen 800 nm und 1000 nm liegt. Das Substrat kann für das Licht dieser Wellenlänge intransparent sein. Zumindest ein Bereich, bevorzugt eine Schicht des ersten und des zweiten Abschnitts, ist für das Licht dieser Wellenlänge transparent.

Die Ermittlung des Korrekturwertes erfolgt bevorzugt bei einer zeitlich konstant gehaltenen Temperatur des Substrates. Hierzu kann das Substrat mit einer konstanten Heizleistung und ohne eine Regelung der Substrattemperatur beheizt werden. Erfindungsgemäss wird das Substrat vor einer Korrekturwert-Bestimmungsphase geregelt auf eine Solltemperatur gebracht wird. Die gemessene Substrattemperatur kann aus den oben genannten Gründen dabei oszillieren. Die Regelung wird unterbrochen, sodass das Substrat nur noch mit konstanter Heizleistung beheizt wird. Nach einer gewissen Zeit, während der die Temperatur des Substrates einen stationären Zustand erreicht, wird in einer Korrekturwertbestimmungsphase, während der die Temperatur des Substrates konstant gehalten wird, nach dem eingangs in Breiland 2003 und in der US 6,398,406 B1 beschriebenen Verfahren ein Korrekturwert bestimmt. Die Bestimmung des Korrekturwertes kann in einem einzigen Schritt erfolgen. Es ist aber auch möglich, während des Abscheidens des ersten Abschnitts der Mehrschichtstruktur mehrere Schritte jeweils zur Bestimmung eines Zwischenkorrekturwertes die Temperatur des Substrates konstant zu halten. Unter Verwendung der oben angegebenen Formeln (1-5) und insbesondere der Formel (5) wird dabei im Wege einer numerischen Optimierung, beispielsweise im Wege einer linearen Regression der Korrekturwert, der von der Reflektanz abhängen kann, derart bestimmt, dass die nach der Formel (5) angegebene berechnete Ist-Temperatur $T_C$ eine minimale Oszillation zeigt. Die zeitliche Länge für die Korrekturwert-Bestimmungsphase oder die Phase zur Bestimmung eines Zwischenkorrekturwertes beträgt zumindest ein Viertel einer Periode der Oszillation und/oder zumindest 40 Sekunden, typischerweise etwa 100 Sekunden.

Die Berechnung des Korrekturwertes kann nicht nur beim Abscheiden des ersten Abschnittes der Mehrschichtstruktur erfolgen. Eine weitere Berechnung des Korrekturwertes kann auch während des Abscheidens des zweiten Abschnittes erfolgen, insbesondere um damit den Korrekturwert, der beim Abscheiden des ersten Abschnittes gewonnen worden ist, zu optimieren.

Mit dem in einem oder mehreren Schritten während des Abscheidens des ersten Abschnitts der Mehrschichtstruktur gewonnenen Korrekturwertes kann dann während des Abscheidens des zweiten Abschnitts die dortige Temperaturmessung korrigiert werden. Die Berechnung sowohl des Korrekturwertes als auch nachfolgend des Istwertes der Temperatur kann durch eine Software der Messeinrichtung oder durch eine Software der Recheneinrichtung erfolgen. Dies kann automatisiert durchgeführt werden. Die Berechnung des Korrekturwertes kann während des Abscheidens des ersten Abschnitts der Mehrschichtstruktur fortlaufend optimiert werden. Die Berechnung des Korrekturwertes erfolgt bevorzugt in einer Phase des Abscheidens der Bauelementstruktur, in der die automatische Temperaturregelung, mit der die Oberflächentemperatur des Substrates auf einen möglichst konstanten Wert gehalten wird, ohne nachteiligen Effekt auf die Schichtstruktur abgeschaltet werden kann. Während der abgeschalteten Regelung erfolgt bevorzugt auch die Parameterbestimmung für die Berechnung der Ist-Temperatur. Als besonders geeignet erweisen sich dabei die zeitlichen Bereiche des Beschichtungsprozesses, in denen eine Übergangs-Schichtenfolge zwischen einer Keimschicht und einer Bufferschicht abgeschieden wird. Auch der Beginn des Abscheidens einer Bufferschicht ist für die Parameterbestimmung und die Bestimmung des Korrekturwertes geeignet. Eine fortlaufende Ermittlung des Korrekturwertes während des Abscheidens der Schichtstruktur ist von Vorteil, da hierbei die reale physikalische Temperatur hinreichend konstant bleiben kann. Für die Ermittlung des Korrekturwertes reicht je nach Güte der Oszillationsverläufe bereits ein Bruchteil einer ganzen Oszillationsperiode aus. Diese Berechnung wäre Teil des Regelkreises und die Ermittlung des Berechnungsfehlers kann als Güte genutzt werden, ob die automatisierte Berechnung für den nächsten Teilabschnitt genutzt wird oder nicht.

Es kann auch vorgesehen sein, den in einem Abscheideprozess berechneten Korrekturwert und/oder die dabei berechneten übrigen Parameter zur Bestimmung des Istwertes der Substrattemperatur in einem anderen Abscheideprozess, der dem erstgenannten Abscheideprozess folgt, zu verwenden.

Die Vorrichtung zur Durchführung des Verfahrens besitzt ein Reaktorgehäuse und ein darin angeordnetes Gaseinlassorgan, mit dem Prozessgase, die ein Hydrid eines Elementes der V. Hauptgruppe und eine metallorganische Verbindung eines Elementes der III. Hauptgruppe aufweisen kann. Die Elemente der V. Hauptgruppe können Stickstoff, Arsen, Phosphor oder Tellur sein. Die Elemente der III. Hauptgruppe können Aluminium, Gallium oder Phosphor sein. Die Prozessgase werden zusammen mit einem Inertgas, beispielsweise Wasserstoff, in eine Prozesskammer eingespeist. Der Boden der Prozesskammer kann von einem Suszeptor gebildet sein. Die Substrate können auf dem Suszeptor aufliegen. Es ist aber auch vorgesehen, dass der Suszeptor ein oder mehrere, insbesondere auf einer Kreisbogenlinie um ein Zentrum des Suszeptors angeordnete Substratträger aufweist, auf denen jeweils mindestens ein Substrat liegt. Das Gaseinlassorgan kann im Zentrum der Prozesskammer angeordnet sein. Nach oben hin wird die Prozesskammer von einer Prozesskammerdecke begrenzt. Diese kann eine Öffnung aufweisen, durch die der Strahlengang einer optischen Messeinrichtung, beispielsweise eines Pyrometers, eines Lasers oder mehrere Pyrometer, hindurchtritt. Der Strahlengang tritt an einer Messstelle auf ein Substrat, sodass mit dem Pyrometer oder den Pyrometern die Reflektanz und die Emissivität der Oberfläche des Substrates beziehungsweise der auf dem Substrat abgeschiedenen Schicht bestimmt werden kann. Gemäß dem eingangs beschriebenen Verfahren kann aus dem Reflektanzwert und dem Emissivitätswert eine Temperatur gemessen werden. Aufgrund der als Folge des stetigen Schichtwachstums sich ändernden Schichtdicke auftretenden Oszillationen der Messwerte, die für die Berechnung der Ist-Temperatur verwendet werden, ist eine Korrektur mit dem oben genannten Verfahren erforderlich. Dies erfolgt unter Verwendung einer Recheneinrichtung der Vorrichtung. Diese ist derart programmiert, dass der Korrekturwert während des Abscheidens eines ersten Abschnitts der Mehrschichtstruktur ermittelt wird und während des Abscheidens eines zweiten Abschnitts der Mehrschichtstruktur verwendet wird.

**Kurze Beschreibung der Zeichnungen**

Ein Ausführungsbeispiel der Erfindung wird nachfolgend anhand beigefügter Zeichnungen erläutert. Es zeigen:

Fig. 1 schematisch in der Darstellung eines Schnittes eine Vorrichtung zur Durchführung des Verfahrens,

Fig. 2 schematisch einen Schnitt gemäß der Linie II-II in Figur 1,

Fig. 3 ein Ausführungsbeispiel einer auf einem Siliziumsubstrat 22 abgeschiedenen Mehrschichtstruktur 21,

Fig. 4 schematisch den zeitlichen Verlauf des Reflektanzwertes R und des Emissivitätswertes E während einer Korrekturwert-Bestimmungsphase sowie die daraus berechnete Temperatur ohne Korrektur und

Fig. 5 in der Art der Darstellung gemäß Figur 4 den Verlauf von Reflektanzwert R, Emissivitätswert E und der daraus berechneten korrigierten Temperatur während des Abscheidens des aktiven Bereiches der Mehrschichtstruktur mit Korrektur. Die Temperatur ist hier schwach oszillierend dargestellt. Optimal besitzt der zeitliche Verlauf der Temperatur keine oder nur geringe Schwankungen, wäre im Diagramm also eine gerade Linie.

**Beschreibung der Ausführungsformen**

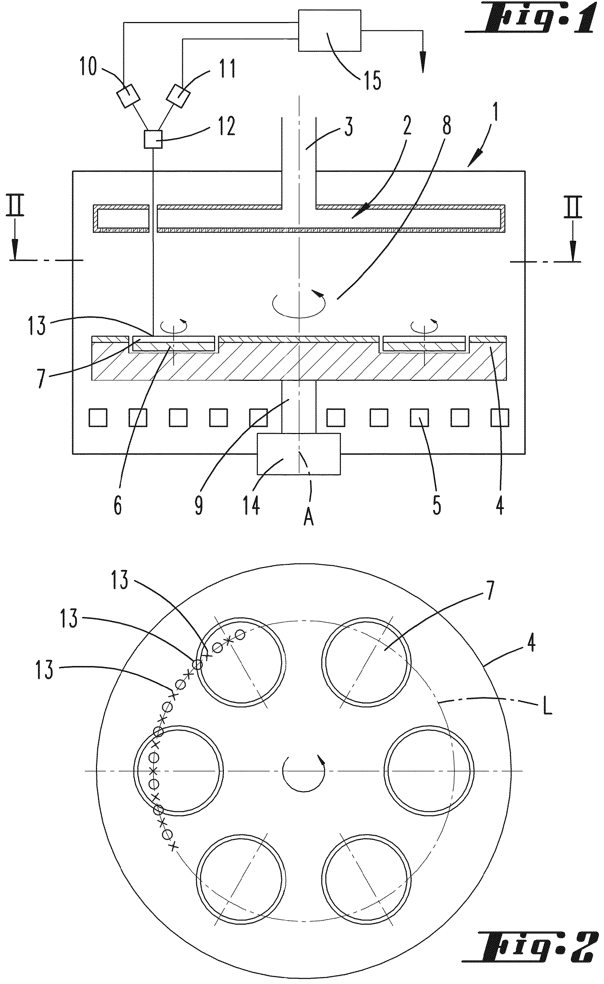

Der in den Figuren 1 und 2 dargestellte CVD-Reaktor besitzt ein Reaktorgehäuse 1, eine darin angeordnete Heizeinrichtung 5, einen oberhalb der Heizeinrichtung 5 angeordneten Suszeptor 4 und ein Gaseinlassorgan 2 zum Einleiten von beispielsweise TMGa, TMAl, $NH_3$, $AsH_3$, $PH_3$ und $H_2$. Der Suszeptor 4 wird mit Hilfe einer Drehantriebseinrichtung 14 um eine vertikale Drehachse a drehangetrieben. Eine Antriebswelle 9 ist hierzu einerseits mit der Drehantriebseinrichtung 14 und andererseits mit der Unterseite des Suszeptors 5 verbunden.

Auf der von der Heizeinrichtung 5 wegweisenden horizontalen Oberfläche des Suszeptors 5 liegen Substrate 7. Es sind Substrathalter 6 vorgesehen, auf denen die Substrate 7 liegen. Die Substrate 7 liegen radial außerhalb der Drehachse a und werden von Substrataufnahmen in Position gehalten.

Es können zwei Messeinrichtungen vorgesehen sein. Eine Emissivitäts-Messeinrichtung 10 kann von einem Pyrometer gebildet sein. Eine Reflektanz-Messeinrichtung 11 kann ebenfalls von einem Pyrometer ausgebildet sein. Es kann einen Strahlteiler 12 vorgesehen sein, mit dem ein Eingangsstrahl auf die beiden Messeinrichtungen 10, 11 aufgeteilt werden kann. Der Strahlengang tritt an einer Messstelle 13 auf das Substrat 7. Die Figur 2 deutet an, dass die Messstelle 13 während einer Drehung des Suszeptors 4 über sämtliche der Substrate 7 wandert.

Die Figur 3 zeigt eine Mehrschichtstruktur 21, die in mehreren aufeinanderfolgenden Beschichtungsschritten in einem Beschichtungsprozess hintereinander abgeschieden werden. Auf das Siliziumsubstrat 22 wird zunächst eine Nukleationsschicht 23 aus AlN oder InN abgeschieden. Auf die Nukleationsschicht 23 wird sodann eine erste AlGaN-Schicht 24, darauf eine zweite AlGaN-Schicht 25 und darauf eine dritte AlGaN-Schicht 26 abgeschieden. Die drei AlGaN-Schichten 24 bis 26 bilden Übergangsschichten aus. Der Aluminiumgehalt der Übergangsschichten kann schrittweise abnehmen.

Auf die Übergangsschichten 24 bis 26 wird sodann eine erste Bufferschicht 27 aus GaN abgeschieden. Die Schicht kann C-dotiert sein. Auf die erste Bufferschicht 27 wird sodann eine zweite Bufferschicht 28 ebenfalls aus GaN abgeschieden, die undotiert sein kann.

Der Bereich der Mehrschichtstruktur 21, beginnend mit der Nukleationsschicht 23 bis in den oberen Bereich der zweiten Bufferschicht 28 wird als erster Abschnitt der Mehrschichtstruktur 21 bezeichnet. Der obere Bereich der Bufferschicht 28, der nicht zum ersten Abschnitt gehört, hat eine Mindestdicke von etwa 100 nm.

Auf die zweite Bufferschicht 28 wird eine Barriereschicht 30 aus AlGaN oder AlInN abgeschieden. Zumindest der untere Bereich der Barriereschicht 30, deren Dicke etwa einem Zehntel der Dicke der zweiten Bufferschicht 28 betragen kann, wird ebenso wie der obere Bereich der zweiten Bufferschicht 28 als zweiter Abschnitt der Mehrschichtstruktur 21 bezeichnet.

In der Figur 3 sind mit den Bezugsziffern 17, 17' zwei Bereiche dargestellt, während derer die Korrekturwerte ermittelt werden. In der Darstellung gemäß Figur 3 sind diese Korrekturwert-Bestimmungsphasen 17, 17' örtlich voneinander und von dem zweiten Abschnitt 19 beabstandet. Beim Abscheiden der Mehrschichtstruktur sind die Korrekturwert-Bestimmungsphasen 17, 17' zeitlich voneinander und vom Beginn des Abscheidens des zweiten Abschnitts 19 beabstandet. Eine optionale Optimierung des Korrekturwertes kann noch während der Zeit des Abscheidens des zweiten Abschnittes 19, also während der Benutzung des Korrekturwertes erfolgen.

Auf die Barriereschicht 30 wird sodann eine Deckschicht aus P-dotiertem GaN abgeschieden. Die Deckschicht 30 und die zweite Bufferschicht 28 können aber auch dem zweiten Abschnitt der Mehrschichtstruktur 21 zugerechnet sein.

Während des Abscheidens des ersten Abschnittes wird ein Istwert $T_C$ einer Substrattemperatur berechnet. Dies kann gemäß der folgenden Formel erfolgen

$$T_C = \frac{B}{\log E - A + \log(1 - R)} \qquad (3)$$

Der Istwert kann aber auch gemäß der folgenden Formel

$$T_C = \frac{B}{\log E - A + \log(1 - \gamma \cdot R)} \qquad (5)$$

berechnet werden. Dabei handelt es sich bei den Bezeichnungen in den obigen Formeln um folgende Größen

$T_C$ :      Emissivitätskorrigierte Temperatur
$E$ :      Kalibriertes Signal der Messung der thermischen Emission (Linearer Zusammenhang zwischen Messsignal und einfallender Strahlung)
$R$ :      kalibriertes Signal der Reflektanzmessung (Linearer Zusammenhang zwischen Messsignal und einfallender Strahlung)
$T_{cal}$, $S_{cal}$:   Kalibrierparameter zur Ermittlung der Rohtemperatur
$R_{cal}$ :     Kalibrierparameter der Reflektanzmessung
$\lambda$:      Wellenlänge von Pyrometer und Reflektanzmessung
$c_2$:      zweite Strahlungskonstante

Die Parameter A und B sowie der Korrekturwert $\gamma$ werden angepasst beziehungsweise berechnet.

Die Messung der Reflektanz der Schicht erfolgt mit der Emissivitäts-Messeinrichtung 10. Aufgrund der stetig wachsenden Schicht und sich ändernden Reflexionen und Schichtdicken hat der Emissivitätswert E einen in der Figur 4 schematisch dargestellten, oszillierenden Verlauf. Der mit der Reflektanz-Messeinrichtung 11 gemessene Reflektanzwert R hat aus denselben Gründen ebenfalls einen oszillierenden Verlauf. Der daraus berechnete Istwert Tc der Substrattemperatur hat ebenfalls einen oszillierenden Verlauf. Der Istwert $T_C$ wird verwendet, um die Substrattemperatur gegen einen Sollwert $T_S$ zu regeln. Die physikalische Temperatur des Substrates, die in der Figur 4 dargestellt ist, hat deshalb ebenfalls einen oszillierenden Verlauf. Die Periodenlänge der Oszillationskurve beträgt etwa 100 bis 200 Sekunden bei einer Wellenlänge von 950 nm und einem Brechungsindex n ungefähr 3.

Während ein oder mehrerer Korrekturwert-Bestimmungsphasen 17, 17' werden während des Abscheidens des ersten Abschnittes ein Korrekturwert $\gamma$ oder mehrere Zwischenkorrekturwerte $\gamma$ ermittelt. Die Länge einer Korrekturwert-Bestimmungsphase 17, 17' beträgt zumindest die Zeit eines Viertels einer Periodenlänge. Vor der Korrekturwert-Bestimmungsphase 17, 17' wird die Temperatur T der Substratoberfläche gegen einen Sollwert geregelt. Aufgrund der Oszillation der Emissivität E und der Reflektanz R, wie sie in der Figur 4 dargestellt ist, oszilliert die Temperatur. Unmittelbar vor der Korrekturwert-Bestimmungsphase 17, 17' wird die physikalische Substrattemperatur T konstantgehalten, indem die Regelung unterbrochen wird. Die Temperatur T erreicht einen stationären Zustand. In der Korrekturwert-Bestimmungsphase 17, 17' wird die Heizeinrichtung 5 nicht geregelt, sondern mit einer konstanten Leistung bestromt. Der Messwert von Emissivität E und Reflektanz R oszilliert. Die Temperatur T bleibt aber konstant. Mit der Recheneinrichtung 15 wird, insbesondere unter Verwendung der Formel (5) ein Korrekturwert $\gamma$ derart variiert, dass die berechnete Temperatur $T_C$ möglichst wenig oszilliert. Dabei werden gleichzeitig die Kalibrierparameter A und B ermittelt.

Die Berechnung des Korrekturwertes $\gamma$ kann auch nach der Korrekturwert-Bestimmungsphase 17, 17' erfolgen. Wesentlich ist, dass in der Korrekturwert-Bestimmungsphase Messwerte aufgenommen werden, mit denen die Berechnung durchgeführt werden kann.

Sind mehrere Korrekturwert-Bestimmungsphasen 17, 17' vorgesehen, so kann der Korrekturwert $\gamma$ schrittweise optimiert werden.

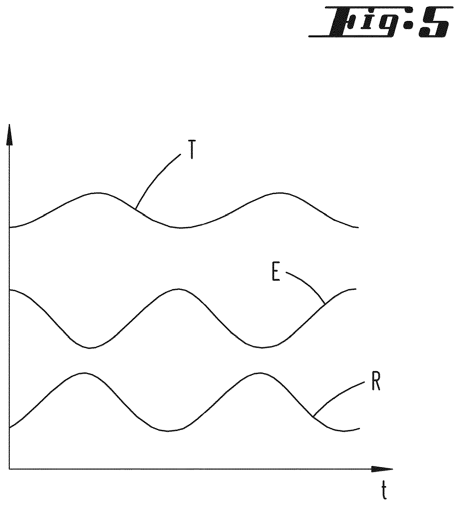

Zum Abscheiden einer Grenzschicht 29 zwischen der oberen Bufferschicht 28 und der darüberliegenden Barriereschicht 30 wird in einem zweiten Abschnitt der Mehrschichtstruktur 19, also in einer Korrekturphase, der Istwert der Substrattemperatur gemäß der Formel (5) berechnet. Die physikalische Temperatur T der Substratoberfläche verläuft dann etwa gemäß Figur 5. Die Oszillation hat eine geringere Amplitude, als die Oszillation der in Figur 4 dargestellten Temperaturkurve. Optimal besitzt die Temperaturkurve überhaupt keine Oszillation mehr. Es ist also insbesondere vorgesehen, dass während des Abscheidens der Bufferschicht 28 und der Barriereschicht 30 zur Bestimmung des Istwertes der Temperatur der Substratoberfläche eine emissivitätskorrigierte Pyrometrie durchgeführt wird, wobei der Korrekturfaktor $\gamma$ unmittelbar vorher während desselben Abscheideprozesses gewonnen wurde.

Die Figur 2 zeigt insgesamt sechs Substrate. Zu jedem Substrat kann ein individuell zugeordneter Korrekturwert $\gamma$ ermittelt werden, der beim Abscheiden des zweiten Abschnitts 19 der Mehrschichtstruktur verwendet wird.

<u>**Liste der Bezugszeichen**</u>

| | | | |
|---|---|---|---|
| 1 | Reaktorgehäuse | 21 | Mehrschichtstruktur |
| 2 | Gaseinlassorgan | 22 | Substrat |
| 3 | Gaszuleitung | 23 | Nukleationsschicht |
| 4 | Suszeptor | 24 | Übergangsschicht |
| 5 | Heizeinrichtung | 25 | Übergangsschicht |
| 6 | Substrathalter | 26 | Übergangsschicht |
| 7 | Substrat | 27 | Bufferschicht |
| 8 | Prozesskammer | 28 | Bufferschicht |
| 9 | Drehachse | 29 | Grenzschicht, zweidimensionales Elektronengas |
| 10 | Emissivitätswert-Messeinrichtung | 30 | Barrierenschicht |
| 11 | Reflektanzwert-Messeinrichtung | 31 | Deckschicht |
| 12 | Strahlteiler | $\gamma$ | Korrekturwert |
| 13 | Messstelle | $\lambda$ | Wellenlänge |
| 14 | Drehantriebseinrichtung | | |
| 15 | Recheneinrichtung | a | Drehachse |
| 17 | Korrekturwert-Bestimmungsphase | A | Kalibrierparameter |
| 17' | Korrekturwert-Bestimmungsphase | B | Kalibrierparameter |
| | | E | Emissivitätswert |
| 18 | erster Abschnitt der Mehrschichtstruktur | R | Reflektanzwert |
| | | $T_C$ | korrigierte Temperatur, Temperatur-Istwert |
| 19 | Korrekturphase, zweiter Abschnitt der Mehrschichtstruktur | $T_M$ | Messtemperatur |
| | | $T_S$ | Temperatur-Sollwert |
| 20 | Bestimmungsphase | | |

**Patentansprüche**

1. Verfahren zur emissivitätskorrigierten Pyrometrie beim Beschichten eines Substrates (22) mit einer Mehrschichtstruktur (21), wobei ein erster Abschnitt (18) der Mehrschichtstruktur (21) erste Schichten (22 bis 28) und ein darauf abgeschiedener zweiter Abschnitt (19) zweite Schichten (30, 31) aufweist, wobei während des Abscheidens zumindest einer der zweiten Schichten (30, 31) des zweiten Abschnitts (19) mit mindestens einer optischen Messeinrichtung (10, 11) an der die Schicht aufweisenden Breitseite des Substrats ein oszillierender Emissivitätswert (E) und ein dazu phasenverschobener oszillierender Reflektanzwert (R) gemessen wird, wobei aus dem Emissivitätswert (E) und dem Reflektanzwert (R) unter Verwendung eines zuvor bestimmten Korrekturwertes ($\gamma$) zur Korrektur von Restoszillationen ein Istwert ($T_C$) einer Temperatur der Breitseite des Substrates (22) berechnet wird und unter Verwendung des Istwertes ($T_C$) eine Heizeinrichtung (5) zum Temperieren des Substrates (22) auf einen Sollwert ($T_S$) der Temperatur der Breitseite des Substrates (22) geregelt wird, wobei der Korrekturwert ($\gamma$) während des unmittelbar vor dem Abscheiden des zweiten Abschnitts (19) durchgeführten Abscheidens einer der ersten Schichten (22, 28) des ersten Abschnitts (18) in situ beim Abscheiden der Mehrschichtstruktur bestimmt wird, wobei das Substrat (22) unmittelbar vor dem Bestimmen des Korrekturwertes ($\gamma$) auf eine zeitlich konstant bleibende Messtemperatur ($T_M$) geheizt wird, bei der der Korrekturwert ($\gamma$) bestimmt wird.

2. Verfahren nach Anspruch 1, **dadurch gekennzeichnet, dass** der erste Abschnitt (18) der Mehrschichtstruktur (21) eine Vielzahl von Buffer- oder Übergangs-Schichten (23 bis 28) aufweist und/ oder dass der zweite Abschnitt (19) der Mehrschichtstruktur (21) zumindest eine Barriereschicht (30) aufweist.

3. Verfahren nach Anspruch 1 oder 2, **dadurch gekennzeichnet, dass** die Messung des Emissivitätswertes (E) und/oder des Reflektanzwertes (R) bei einer Wellenlänge ($\lambda$) in einem Bereich zwischen 800 nm und 1000 nm durchgeführt wird.

4. Verfahren nach einem der vorhergehenden Ansprüche, **dadurch gekennzeichnet, dass** das Substrat (22) für Licht der Wellenlänge ($\lambda$), bei der der Emissivitätswert (E) und/oder der Reflektanzwert (R) gemessen wird, intransparent ist, und die Schichten des ersten Abschnittes und des zweiten Abschnittes (19), zumindest aber die Schichten im Bereich des zweiten Abschnittes (19) transparent oder semi-transparent sind.

5. Verfahren nach einem der vorhergehenden Ansprüche, **dadurch gekennzeichnet, dass** während einer Korrekturwert-Bestimmungsphase (17, 17') das Substrat (22) ohne Temperaturregelung mit konstanter Heizleistung beheizt wird.

6. Verfahren nach einem der vorhergehenden Ansprüche, **dadurch gekennzeichnet, dass** sich der Emissivitätswert (E) und der Reflektanzwert (R) während des Abscheidens der Mehrschichtstruktur (21) periodisch ändert, wobei die zeitliche Länge Korrekturwert-Bestimmungsphase (17, 17') zumindest ein Viertel der Periode und/oder maximal eine halbe oder ganze Periode und/ oder maximal 100 Sekunden beträgt.

7. Verfahren nach einem der vorhergehenden Ansprüche, **dadurch gekennzeichnet, dass** die Bestimmung des Korrekturwertes ($\gamma$) in mehreren zeitlich jeweils nach einer Pause aufeinanderfolgenden Korrekturwert-Bestimmungsphasen (17, 17') durchgeführt wird, wobei jeweils ein Zwischenkorrekturwert bestimmt wird, wobei der Korrekturwert ($\gamma$) unter Verwendung der Zwischenkorrekturwerte berechnet wird oder ein Zwischenkorrekturwert zur Optimierung des Korrekturwertes ($\gamma$) während des Abscheidens des zweiten Abschnittes (19) bestimmt wird.

8. Verfahren nach einem der vorhergehenden Ansprüche, **dadurch gekennzeichnet, dass** das Substrat (22) ein Siliziumsubstrat ist und/oder dass die Mehrschichtstruktur (21) Schichten aus Elementen der III. und V. Hauptgruppe aufweist.

9. Verfahren nach einem der vorhergehenden Ansprüche, **dadurch gekennzeichnet, dass** die ein oder mehreren Buffer- oder Übergangs-Schichten (23 bis 28), bei deren Abscheiden der Korrekturwert ($\gamma$) bestimmt wird, Gallium, Stickstoff und/oder Aluminium enthält.

10. Verfahren nach einem der vorhergehenden Ansprüche, **dadurch gekennzeichnet, dass** die Barriereschicht (30) eine AlGaN-Schicht oder eine AlInN-Schicht ist.

11. Verfahren nach einem der vorhergehenden Ansprüche, **dadurch gekennzeichnet, dass** der erste Abschnitt (18) zumindest eine Schicht (23 bis 26) aufweist, die hinsichtlich ihrer Zusammensetzung zumindest einer Schicht (30) des zweiten Abschnitts (19) ähnlich ist.

12. Verfahren nach einem der vorhergehenden Ansprüche, **dadurch gekennzeichnet, dass** in einem Reaktorgehäuse (1) eines CVD-Reaktors auf einem von einer Heizeinrichtung (5) beheizten Suszeptor (4) mehrere Substrate (22) gleichzeitig mit einer Mehrschichtstruktur (21) beschichtet werden, wobei zu jedem der Substrate (22) ein individueller Korrekturwert ($\gamma$) berechnet wird und mit dem individuellen Korrekturwert ($\gamma$) ein individueller Istwert ($T_C$) einer Temperatur des Substrates (22) berechnet wird.

13. Vorrichtung zur Durchführung des Verfahrens nach einem der vorhergehenden Ansprüche mit einem in einem Reaktorgehäuse (1) angeordneten Gaseinlassorgan (2), durch welches Prozessgase in eine Prozesskammer (8) eingespeist werden, einem eine zur Prozesskammer (8) weisende Fläche aufweisenden Suszeptor (4), der von einer Heizeinrichtung (5) beheizbar ist und auf dessen zur Prozesskammer (8) weisenden Fläche Substrate (22) anordbar sind, mit ein oder mehreren optischen Messeinrichtungen (10, 11) zur Messung eines Emissivitätswertes (E) und eines Reflektanzwertes (R) einer zur Prozesskammer (8) weisenden Breitseite des Substrates (22) und mit einer Regeleinrichtung zur Regelung der Temperatur des Substrates (22) unter Verwendung der von der mindestens einen optischen Messeinrichtung (10, 11) gemessenen Emissivitätswerte (E) und Reflektanzwerte (R), wobei eine Recheneinrichtung (15) einen Korrekturwert ($\gamma$) bestimmt und unter Verwendung des Korrekturwertes ($\gamma$) einen Istwert (Tc) der Temperatur berechnen kann, wobei die Recheneinrichtung (15) derart programmiert ist, dass der Korrekturwert ($\gamma$) während des Abscheidens einer ersten Schicht (22 bis 28) des ersten Abschnitts (18) der Mehrschichtstruktur (21) auf dem Substrat (22) unmittelbar vor dem Abscheiden der zweiten Schichten (30, 31) des zweiten Abschnitts (19) der Mehrschichtstruktur (21) auf den ersten Schichten (22, 28) des ersten Abschnitts (18) nach einem Verfahren gemäß einem der Ansprüche 1 bis 12 bestimmt wird.

**Claims**

1. Method for emissivity-corrected pyrometry when coating a substrate (22) with a multilayer structure (21), wherein a first portion (18) of the multilayer structure (21) includes first layers (22 to 28), and a second portion (19) deposited thereon includes second layers (30, 31), wherein during the deposition of at least one of the second layers (30, 31) of the second portion (19) an oscillating emissivity value (E) of the broad side of the substrate having the coating and an oscillating reflectance value (R) phase-shifted with respect thereto is measured with at least one optical measuring device (10, 11), wherein an actual value ($T_C$) of a temperature of the broad side of the substrate (22) is calculated from the emissivity value (E) and the reflectance value (R) using a previously determined correction value ($\gamma$) for correcting residual oscillations, and a heating device (5) is regulated for regulating the temperature of the substrate (22) to a target value ($T_S$) of the temperature of the broad side of the substrate (22) using the actual value ($T_C$), wherein the correction value ($\gamma$) is determined during the deposition of one of the first layers (22, 28) of the first portion (18) in situ during deposition of the multilayer structure carried out immediately before the deposition of the second portion (19), wherein immediately before the determination of the correction value ($\gamma$) the substrate (22) is heated to a temporally constantly maintained measurement temperature ($T_M$), at which the correction value ($\gamma$) is determined.

2. Method according to Claim 1, **characterized in that** the first portion (18) of the multilayer structure (21) includes a multiplicity of buffer- or transition layers (23 to 28), and/or that the second portion (19) of the multilayer structure (21) includes at least one barrier layer (30).

3. Method according to Claim 1 or 2, **characterized in that** the measurement of the emissivity value (E) and/or of the reflectance value (R) is carried out at a wavelength ($\lambda$) in a range between 800 nm and 1000 nm.

4. Method according to any one of the preceding claims, **characterized in that** the substrate (22) is non-transparent for light of the wavelength (A) at which the emissivity value (E) and/or the reflectance value (R) is measured, and the layers of the first portion and of the second portion (19), but at least the layers in the region of the second portion (19) are transparent or semi-transparent.

5. Method according to any one of the preceding claims, **characterized in that** during a correction value determination phase (17, 17') the substrate (22) is heated with constant heat output without temperature regulation.

6. Method according to any one of the preceding claims, **characterized in that** during deposition of the multilayer structure (21) the emissivity value (E) and the reflectance value (R) changes periodically, wherein temporal length correction value determination phase (17, 17') is at least equal to a quarter of the period and/or maximally a half or a whole period, and/or maximally 100 seconds.

7. Method according to any one of the preceding claims, **characterized in that** the determination of the correction value ($\gamma$) is carried out in number of correction value determination phases (17, 17'), each being completed temporally consecutively after a pause, wherein an intermediate correction value is determined in each case, wherein the correction value ($\gamma$) is calculated using the intermediate correction values, an intermediate correction value is determined during the deposition of the second portion (19) in order to optimise the correction value (y).

8. Method according to any one of the preceding claims, **characterized in that** the substrate (22) is a silicon substrate and/or that the multilayer structure (21) includes layers of elements from main group III and V.

9. Method according to any one of the preceding claims, **characterized in that** the one or more buffer- or transition layers (23 to 28), during whose deposition the correction value ($\gamma$) is determined, contains, gallium, nitrogen and/or aluminium.

10. Method according to any one of the preceding claims, **characterized in that** the barrier layer (30) is an AlGaN layer or an AlInN layer.

11. Method according to any one of the preceding claims, **characterized in that** the first portion (18) includes at least one layer (23 to 26) which is similar to at least one layer (30) of the second portion (19) in terms of its composition.

12. Method according to any one of the preceding claims, **characterized in that** in a reactor housing (1) of a CVD reactor multiple substrates (22) on a susceptor (4) which is heated by a heating device (5) are coated simultaneously with a multilayer structure (21), wherein an individual correction value ($\gamma$) is calculated for each of the substrates (22), and an individual actual value (T$_C$) of a temperature of the substrate (22) is calculated with the individual correction value (γ).

13. Apparatus for performing the method according to any one of the preceding claims, with a gas inlet element (2) arranged in a reactor housing (1), through which process gases are fed into a process chamber (8), a susceptor (4) with a surface facing towards the process chamber (8), wherein the susceptor is heatable by a heating device (5), and wherein substrates (22) can be arranged on the surface of said susceptor facing the process chamber (8), with one or more optical measuring devices (10, 11) for measuring an emissivity value (E) and a reflectance value (R) of a broad side of the substrate (22) facing the process chamber (8), and with a regulating device for regulating the temperature of the substrate (22) using the emissivity values (E) and reflectance values (R) measured by the at least one optical measuring device (10, 11), wherein a computing device (15) determines a correction value (γ), and can calculate an actual value (T$_C$) of the temperature using the correction value (γ), wherein the computing device (15) is programmed in such manner that the correction value (γ) is determined during the deposition of a first layer (22 to 28) of the first portion (18) of the multilayer structure (21) on the substrate (22), immediately before the deposition of the second layers (30, 31) of the second portion (19) of the multilayer structure (21) on the first layers (22, 28) of the first portion (18), according to a method as described in any one of Claims 1 to 12.

**Revendications**

1. Procédé de pyrométrie à correction d'émissivité lors du revêtement d'un substrat (22) avec une structure multicouche (21), dans lequel une première section (18) de la structure multicouche (21) comporte des premières couches (22 à 28) et une deuxième section (19) déposée par-dessus comporte des deuxièmes couches (30, 31), dans lequel, pendant le dépôt d'au moins l'une des deuxièmes couches (30, 31) de la deuxième section (19), une valeur d'émissivité oscillante (E) et une valeur de réflectance oscillante (R) déphasée par rapport à celle-ci sont mesurées avec au moins un dispositif de mesure optique (10, 11) sur la face large du substrat comportant la couche, dans lequel une valeur réelle (T$_C$) de la température de la face large du substrat (22) est calculée à partir de la valeur d'émissivité (E) et de la valeur de réflectance (R), en utilisant une valeur de correction (γ) déterminée préalablement pour corriger les oscillations résiduelles, et un dispositif de chauffe (5) pour tempérer le substrat (22) est régulé à une valeur de consigne (T$_S$) de la température de la face large du substrat (22) en utilisant la valeur réelle (T$_C$), dans lequel la valeur de correction (γ) est déterminée in situ pendant le dépôt de l'une des premières couches (22, 28) de la première section (18) immédiatement avant le dépôt de la deuxième section (19) lors du dépôt de la structure multicouche, dans lequel, immédiatement avant la détermination de la valeur de correction (γ), le substrat (22) est chauffé à une température de mesure (T$_M$) temporellement constante à laquelle la valeur de correction (γ) est déterminée.

2. Procédé selon la revendication 1, **caractérisé en ce que** la première section (18) de la structure multicouche (21) comporte une pluralité de couches tampons ou de transition (23 à 28) et/ou **en ce que** la deuxième section (19) de la structure multicouche (21) comporte au moins une couche barrière (30).

3. Procédé selon la revendication 1 ou 2, **caractérisé en ce que** la mesure de la valeur d'émissivité (E) et/ou de la valeur de réflectance (R) est effectuée à une longueur d'onde (λ) dans une plage comprise entre 800 nm et 1000 nm.

4. Procédé selon l'une des revendications précédentes, **caractérisé en ce que** le substrat (22) n'est pas transparent à la lumière à la longueur d'onde (λ) à laquelle la valeur d'émissivité (E) et/ou la valeur de réflectance (R) est mesurée, et les couches de la première section et de la deuxième section (19), mais au moins les couches dans la région de la deuxième section (19), sont transparentes ou semi-transparentes.

5. Procédé selon l'une des revendications précédentes, **caractérisé en ce que**, pendant une phase de détermination d'une valeur de correction (17, 17'), le substrat (22) est chauffé avec une puissance de chauffe constante sans régulation de température.

6. Procédé selon l'une des revendications précédentes, **caractérisé en ce que** la valeur d'émissivité (E) et la valeur de réflectance (R) changent périodiquement pendant le dépôt de la structure multicouche (21), dans lequel la durée temporelle de la phase de détermination d'une valeur de correction (17, 17°) est d'au moins un quart de période et/ou d'au maximum une demi-période ou une période entière et/ou d'au maximum 100 secondes.

7. Procédé selon l'une des revendications précédentes, **caractérisé en ce que** la détermination de la valeur de correction (γ) est effectuée en plusieurs phases de détermination d'une valeur de correction (17, 17') qui se succèdent dans le temps après une pause, dans lequel une valeur de correction intermédiaire est à chaque fois déterminée, la valeur de correction (γ) étant calculée en utilisant les valeurs de correction intermédiaires ou une valeur de correction intermédiaire étant déterminée pour optimiser la valeur de correction (γ) pendant le dépôt de la deuxième section (19).

8.  Procédé selon l'une des revendications précédentes, **caractérisé en ce que** le substrat (22) est un substrat de silicium et/ou **en ce que** la structure multicouche (21) comprend des couches d'éléments des groupes principaux III et V du tableau périodique.

9.  Procédé selon l'une des revendications précédentes, **caractérisé en ce que** lesdites une ou plusieurs couches tampons ou de transition (23 à 28), lors du dépôt desquelles la valeur de correction (γ) est déterminée, contiennent du gallium, de l'azote et/ou de l'aluminium.

10. Procédé selon l'une des revendications précédentes, **caractérisé en ce que** la couche barrière (30) est une couche d'AlGaN ou une couche d'AlInN.

11. Procédé selon l'une des revendications précédentes, **caractérisé en ce que** la première section (18) comporte au moins une couche (23 à 26) dont la composition est similaire à celle d'au moins une couche (30) de la deuxième section (19).

12. Procédé selon l'une des revendications précédentes, **caractérisé en ce que**, dans une enceinte de réacteur (1) d'un réacteur de dépôt chimique en phase vapeur, plusieurs substrats (22) sont revêtus simultanément d'une structure multicouche (21)sur un suscepteur (4) chauffé par un dispositif de chauffe (5), dans lequel une valeur de correction individuelle (γ) est calculée pour chacun des substrats (22) et une valeur réelle individuelle ($T_C$) d'une température du substrat (22) est calculée à l'aide de la valeur de correction individuelle (γ).

13. Dispositif pour la mise en œuvre du procédé selon l'une des revendications précédentes, comprenant un élément d'admission de gaz (2) agencé dans une enceinte de réacteur (1), à travers lequel les gaz de procédé sont injectés dans une chambre de procédé (8), un suscepteur (4) présentant une surface tournée vers la chambre de procédé (8), qui peut être chauffé par un dispositif de chauffe (5) et sur lequel des substrats (22) peuvent être agencés, avec un ou plusieurs dispositifs de mesure optique (10, 11) pour mesurer une valeur d'émissivité (E) et une valeur de réflectance (R) d'une face large du substrat (22) faisant face à la chambre de procédé (8) et avec un dispositif de régulation pour réguler la température du substrat (22) en utilisant les valeurs d'émissivité (E) et les valeurs de réflectance (R) mesurées par ledit au moins un dispositif de mesure optique (10, 11), dans lequel un dispositif de calcul (15) détermine une valeur de correction (γ) et peut calculer une valeur réelle ($T_C$) de la température en utilisant la valeur de correction (γ), dans lequel le dispositif de calcul (15) est programmé de telle sorte que la valeur de correction (γ) est déterminée pendant le dépôt d'une première couche (22 à 28) de la première section (18) de la structure multicouche (21) sur le substrat (22) immédiatement avant le dépôt des deuxièmes couches (30, 31) de la deuxième section (19) de la structure multicouche (21) sur les premières couches (22, 28) de la première section (18) par un procédé selon l'une des revendications 1 à 12.

Fig. 1

Fig. 2

_Fig. 3_

| PGaN | | 60nm |
|---|---|---|
| AlGaN | Barriere | 11nm |
| GaN-2 | Puffer | 1050nm |
| GaN-1 | Puffer | 320nm |
| AlGaN-3 | Transition | 730nm |
| AlGaN-2 | Transition | 410nm |
| AlGaN-1 | Transition | 170nm |
| HT-AlN | Nukleation | 160nm |
| Si(111) | | 1000μm |

_Fig. 4_

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 6398406 B1

- DE 102018106481 A1

**In der Beschreibung aufgeführte Nicht-Patentliteratur**

- **W. G. BREILAND**. *Technical Report SAND2003-1868*, June 2003